# EUROPEAN PATENT APPLICATION

(11) **EP 2 547 183 A1**
(43) Date of publication of application: **16.01.2013**
(21) Application number: 11450093.7
(22) Date of filing: 15.07.2011
(51) Int. Cl.: H05K 3/46, H05K 3/00

(54) **Method of manufacturing a rigid-flex printed circuit board or a sub-assembly thereof as well as rigid-flex printed circuit board or a sub-assembly thereof**

(71) Applicant: AT & S Austria Technologie & Systemtechnik Aktiengesellschaft, 8700 Leoben-Hinterberg (AT); Multi-Fineline Electronix, Inc., Anaheim, CA 92806 (US)
(72) Inventor: Sebanz, Simon, 8700 Leoben (AT); Voraberger, Hannes, 8045 Graz (AT); McConnell, Richard, Orange, CA 92869 (US); Chau, Luis, Irvine, CA 92620 (US)
(74) Representative: Miksovsky, Alexander

(57) **Abstract**

A method of manufacturing a rigid-flex printed circuit board or a sub-assembly thereof comprises the following steps:
- providing a layer of rigid insulating material (1)
- removing at least one area of the rigid insulating material
- inserting a flexible insulating material (3) into the removed or cut-out area(s) of the rigid insulating material (1)
- covering the rigid and flexible insulating material (1, 3) with a layer (4) of conductive material on at least one surface
- building up at least one further layer (5, 6, 7, 8) of the rigid-flex printed circuit board (10) at least on the rigid part(s) of the insulating material.

Furthermore a rigid-flex printed circuit board (10) or sub-assembly thereof is provided.

## Description

The present invention relates to a method of manufacturing a rigid-flex printed circuit board or a sub-assembly thereof as well as a rigid-flex printed circuit board or a sub-assembly thereof.

Such a rigid-flex printed circuit board or a sub-assembly thereof can for example be taken from EP 2 034 810 A1 or US 2009/0283301 A1. With these known embodiments it is necessary to insert a flexible material comprising a conductor pattern into respective recesses of rigid part(s) of a printed circuit board having already been provided with conductors or conductive elements. After having inserted the flexible part or element of the rigid-flex printed circuit board it is furthermore necessary to provide vias or similar structures for allowing a contact between the flexible element as well as the rigid element, and in particular the conductive patterns of these elements. Taking into account the small dimensions of conductors or conductive elements of a printed circuit board it is therefore necessary to precisely position the flexible element in the respective recess of the rigid element(s) for allowing a proper contacting thereof. Furthermore respective steps have to be taken for allowing a proper connection between the rigid substrate(s) and the flexible substrate of the rigid-flex printed circuit board.

The present invention thus aims to avoid or minimize the above mentioned problems according to the prior art when providing or producing a rigid-flex printed circuit board, wherein it is particularly aimed at providing a method as well as a rigid-flex printed circuit board or a sub-assembly thereof allowing a simplified connection between the rigid and flexible element(s) and in particular avoiding difficult and time-consuming steps for providing a proper contact between conductive patterns of the rigid and the flexible elements of the printed circuit board.

To solve these objects a method of manufacturing a rigid-flex printed circuit board or a sub-assembly thereof essentially comprises the following steps:
- providing a layer of rigid insulating material
- removing at least one area of the rigid insulating material
- inserting a flexible insulating material into the removed or cut-out area(s) of the rigid insulating material
- covering the rigid and flexible insulating material with a layer of conductive material on at least one surface
- building up at least one further layer of the rigid-flex printed circuit board at least on the rigid part(s) of the insulating material.

By providing a layer of rigid insulating material having inserted a flexible insulating material into at least one removed or cut-out area and furthermore covering the rigid and flexible insulating material(s) with a layer of conductive material on at least one surface it is possible to provide core element or core material of a rigid-flex printed circuit board having already defined the flexible portion thereof in the core substrate. By inserting a flexible insulating material in the cut-out or removed area of the rigid insulating material it will be possible to simply connect these insulating materials, whereafter after covering these insulating materials with a layer of conductive material a simple conductive pattern or structure can be provided both on the flexible part(s) as well as the rigid part(s) of the printed circuit board or a sub-assembly thereof to be provided. In contrast to the prior art it is therefore not necessary to provide vias or holes with great precision to allow a contact between the flexible and rigid elements of the printed circuit board. Furthermore, according to the invention, it is possible to provide a proper as well as reliable connection between the rigid as well as flexible elements by directly positioning the conductive material on at least one surface of the rigid-flex core substrate. After having provided such core substrate comprising already at least one clearly defined flexible portion of a rigid-flex printed circuit board to be produced according to the invention at least one further layer of the rigid-flex printed circuit board will be built up at least on the rigid part(s) of the insulating material allowing a simple structuring as well as manufacturing of such rigid-flex printed circuit board.

As has already indicated above, by providing a rigid-flex core substrate comprising rigid insulating material as well as at least one portion or part of flexible insulating material the production of such rigid-flex printed circuit board and in particular providing a contact between conductive elements thereof can be simplified. In this context it is proposed according to a preferred embodiment of the inventive method that the layer of conductive material is structured after having been connected, in particular laminated with the rigid and flexible insulating material. It is therefore possible to provide a core substrate comprising rigid as well as flexible elements as well as a conductive pattern according to the requirements of the rigid-flex printed circuit board to be produced without necessitating additional steps for providing vias or holes allowing a contacting between conductive parts of rigid element(s) as well as the flexible element of the rigid-flex printed circuit board.

In particular for allowing a build up of further layers of a multi-layer printed circuit board on both sides of the rigid-flex core substrate it is furthermore proposed that the rigid and flexible insulating material are covered with a layer of conductive material on both surfaces according to a further preferred embodiment of the invention.

In this context it is furthermore proposed that preferably the layer(s) of conductive material consist(s) of copper.

In many cases it is preferred to provide further layers of the rigid-flex printed circuit board to be produced covering essentially the whole area of the printed circuit board for allowing the usage of known method steps as well as known apparatus for producing such printed circuit boards. In this context it is therefore proposed that preferably the at least one further layer of the rigid-flex printed circuit board is provided on the rigid and the flexible part(s) of the insulating material and is removed at least partially according to the flexible part of the insulating material. It is thus possible to use known method steps as well as devices for producing a printed circuit board, in particular comprising several layers of conductive as well as insulating or non-conductive materials, whereafter after completion of the build up of the printed circuit board the flexible part(s) are exposed by removing the further layer(s) of the printed circuit board overlapping the flexible part of the insulating material or core.

For enhancing the connection between the rigid and flexible parts or elements of the printed circuit board it is furthermore proposed that the at least one further layer of the rigid-flex printed circuit board is partly overlapping the flexible area(s) of the insulating material.

A reliable connection between the rigid insulating material and the flexible insulating material being part of the rigid flexible core substrate can be preferably be provided by gluing or similar connecting techniques.

For providing a printed circuit board comprising flexible parts or elements at different levels of the rigid-flex printed circuit board it is furthermore preferably proposed that after building up further layers of the rigid-flex printed circuit board at least on the rigid part(s) of the insulating material another layer of rigid insulating material is provided comprising at least one flexible part being aligned with the flexible part(s) of the basic rigid and flexible insulating material.

For allowing a simple production, in particular using known materials for producing printed circuit boards, it is furthermore proposed that at least the rigid insulating material consists of an insulating prepreg, in particular FR4 or a similar insulating material according to further preferred embodiment of the inventive method.

To solve the objects mentioned above a rigid-flex printed circuit board or a sub-assembly thereof essentially comprises the following elements:
- a rigid insulating material comprising at least one area of flexible insulating material having been inserted into a cut-out area of the rigid insulating material
- at least one layer of conductive material on at least one surface of the rigid and flexible insulating material
- at least one further layer of the rigid-flex printed circuit board being provided at least on the rigid part(s) of the insulating material.

As has already been indicated above it is thus possible according to the present invention to provide a rigid-flex printed circuit board or a sub-assembly thereof starting from a core material comprising rigid as well flexible parts or materials and at least one layer of conductive material allowing a simple and reliable connection between the rigid and flexible part(s) of the printed circuit board to be produced as well as a simple and reliable production of conductive patterns or structures both on the rigid parts as well the flexible part of the printed circuit board. In particular it is not necessary to position the flexible part of the rigid-flex printed circuit board with high precision relatively to the rigid parts or elements. Furthermore it is not necessary to provide vias or holes for allowing a contact between conductive patterns or structures of the rigid parts as well as the flexible parts of the printed circuit board as has been necessary with the known prior art.

According to a preferred embodiment it is proposed that a layer of structured conductive material is provided on at least one surface of the rigid and flexible insulating material, thereby providing a simple and reliable conductive pattern or structure both on the rigid as well as flexible parts or elements of the printed circuit board.

For allowing a build up of a multilayer printed circuit board on both sides of the rigid-flex core substrate comprising rigid insulating material as well as flexible insulating material it is furthermore proposed that the printed circuit board comprises a layer of structured conductive material on both surfaces of the rigid and flexible insulating material according to a preferred embodiment of the invention.

As has been already indicated above, in certain cases a build up of further layers of the printed circuit board covering both the rigid as well as flexible parts may be preferred taking into account known method steps. In such case it is preferred according to further embodiment of the present invention that the at least one further layer of the rigid-flex printed circuit board is provided on the rigid and the flexible part(s) of the insulating material and is removed at least partially according to the flexible part of the insulating material.

For allowing a reliable and safe connection between the rigid and flexible elements of the rigid-flex printed circuit boards to be produced as well as avoiding excessive strains or stresses on the flexible parts thereof it is furthermore proposed that the at least one further layer of the rigid-flex printed circuit board is partly overlapping the flexible area(s) of the insulating material according to further preferred embodiment of the invention.

For providing a rigid-flex printed circuit board comprising flexible parts or elements at different levels of a multilayer structure it is furthermore proposed according to a preferred embodiment that the printed circuit board comprises at least two layers of rigid and flexible insulating material being separated by at least one further layer of the rigid-flex printed circuit board, where the areas of flexible insulating material are aligned with each other.

A reliable conductive structure or pattern will be provided when the layer(s) of conductive material are made of copper, as in correspondence with a further preferred embodiment of the invention.

In this context it is furthermore proposed according to a preferred embodiment that at least the rigid insulating material consists of an insulating prepreg, in particular FR4 or a similar insulating material.

In summary, according to the invention there is provided a method of manufacturing a rigid-flex printed circuit board or a sub-assembly thereof avoiding the necessity of inserting a flexible part or element of a rigid-flex printed circuit board into recesses of rigid parts of such printed circuit board with high precision and furthermore requiring additional steps for providing contacts between the flexible and rigid parts or elements. The flexible portion or part of the rigid-flex printed circuit board is already provided and defined in the core substrate comprising rigid as well as flexible parts or elements. This core substrate is furthermore laminated or provided with at least one layer of conductive material on one surface which can be produced beforehand and taking into account in particular the dimensions as well the position of the flexible part of the rigid-flex printed circuit board to be produced. By providing such core substrate comprising rigid as well as flexible parts or elements as well as at least one layer of conductive material on one surface there can be ascertained a reliable and safe connection between the flexible as well as rigid parts and elements. Furthermore by simply structuring the conductive material or layer of such laminated core substrate it will be possible to provide a conductive structure or pattern both on the rigid part(s) as well as the flexible part(s) thereby providing the electrical connection between these elements. It is thus possible to produce or provide a rigid-flex printed circuit board or a sub-assembly thereof with less process steps and to provide a selective core substrate being less expensive, in particular taking into account the simple construction. Furthermore a registration of the elements of the printed circuit board, in particular during following production steps is simplified and the requirements regarding registration or precision of positioning both for connecting the rigid and flexible elements or parts as well as during the build up of further layers of a multilayer printed circuit board are reduced. In particular it is not necessary to take special care regarding the flexible parts or elements being defined in the core substrate comprising rigid as well as flexible parts or areas, resulting in the possibility of using standard alignment devices normally being used with the production of printed circuit boards. As has already been indicated above, it will furthermore be possible to provide complex rigid-flex printed circuit boards having two or more different layers of flexible parts or elements at different levels thereof. Furthermore it will be possible to place or position a flexible element or layer in different positions of a multilayer printed circuit board.

In the following the invention will be explained in more detail by way of exemplary embodiments schematically illustrated in the accompanying drawing. Therein:
Figs. 1 to 1g depict different steps of a method according to the invention for manufacturing a rigid-flex printed circuit board or a sub-assembly thereof according to the invention;
Fig. 2 depicts a modified embodiment of a rigid-flex printed circuit board according to the invention providing two flexible parts or elements at different levels of the printed circuit board; and
Fig. 3 is a schematic drawing of a further alternative embodiment of a rigid-flex printed circuit board according to the invention.

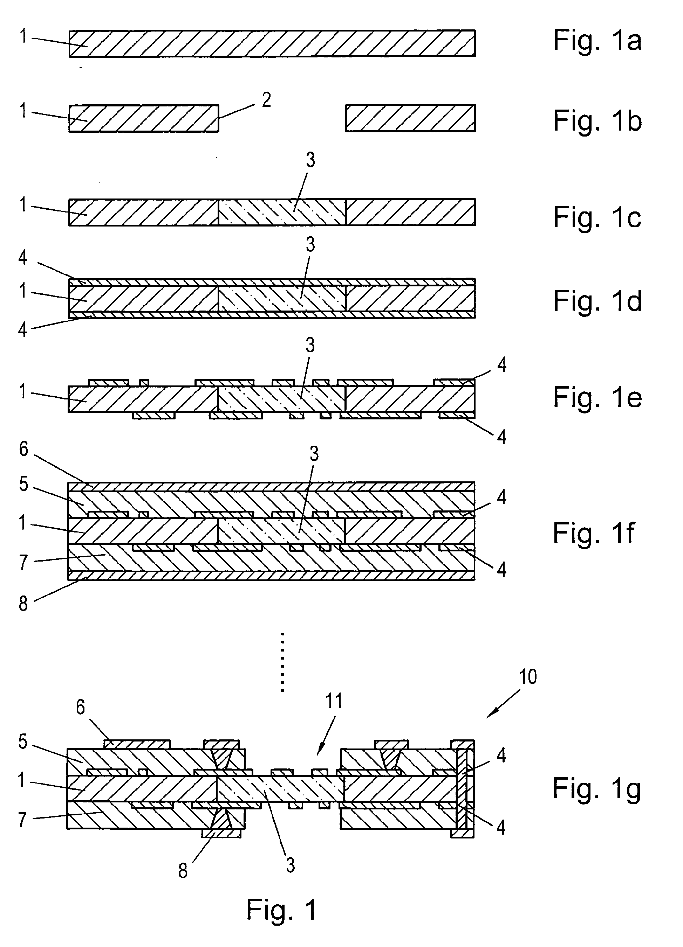

In a first method step according to Fig. 1a a rigid insulating layer 1 of a rigid insulating material, for example an insulating prepreg, in particular FR4, is provided.

According to Fig. 1b in a further method step an area 2 is removed from the rigid insulating material 1.

In this cut-out area a flexible insulating material 3 is inserted according to Fig. 1c.

Thereafter on at least one surface, and in particular on both surfaces, as can be taken from the method step being shown in Fig. 1d, layers 4 of conductive material are provided on both surfaces of the rigid insulating material 1 as well as the flexible insulating material 3 having been inserted into the removed or cut-out area.

According to the method step being shown in Fig. 1d there is provided a core substrate comprising both rigid as well as flexible insulating materials 1 and 3 and layers 4 of conductive material allowing a further build up of further layers of a printed circuit board or sub-assembly thereof to be provided, as can be taken from the following figures.

In Fig. 1e it is furthermore shown that the layers 4 of conductive material, having been provided according to Fig. 1d, are structured for providing a conductive structure or pattern on both surfaces or sides of the core substrate comprising rigid as well as flexible parts or elements 1 and 3.

Thereafter according to Fig. 1f further layers of a multilayer printed circuit board being designated as 5, 6, 7 and 8 are provided. From Fig. 1f it can be clearly taken that these further layers are overlapping both the rigid as well as flexible elements 1 and 3 of the core substrate as well as the structured layers 4 allowing the usage of known production methods or steps for producing printed circuit boards.

In particular the method steps being shown in Fig. 1e and 1f for structuring any conductive layers, being designated with 6 and 8 in Fig. 1f as well a further build up of multiple layers of the printed circuit board can be repeated several times according to the respective requirements, being schematically indicated with the vertical line of points in Fig. 1.

After completion of the build up of the printed circuit board being indicated generally with 10 in Fig. 1g any part(s) of the multilayer structure of the circuit board 10 overlapping the flexible element or part 3 of the core substrate will be removed, being indicated with 11 in Fig. 1g.

Thereby the flexible part of the rigid-flex printed circuit board 10 being provided according to Fig. 1g can be provided on the basis of the position of the flexible insulating material 3 of the rigid-flex core substrate.

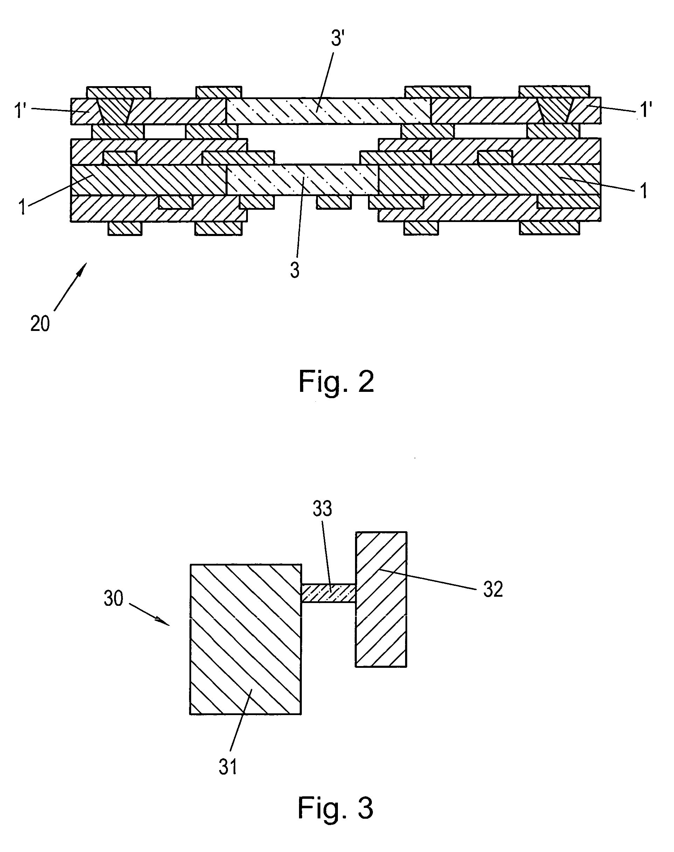

From Fig. 2 it can be taken that by providing several layers of core material, each comprising rigid parts or elements 1 and 1' as well as flexible parts or elements 3 and 3' it will be possible to produce a multilayer rigid-flex printed circuit board 20 comprising flexible parts or elements 3 and 3' at different levels of the multilayer printed circuit board 20.

Both from Fig. 1g as well as Fig. 2 it can be taken that any further layers building up the multilayer rigid-flex printed circuit board 10 or 20 are partly overlapping the region of contact between the rigid parts or elements 1 and 1' with the flexible elements 3 and 3' providing a better connection of the rigid and flexible parts 1 or 1' and 3 or 3' and avoiding excessive strains or mechanical stresses, in particular on the flexible parts 3 or 3'.

In Fig. 3 there is schematically shown a further alternative embodiment of a rigid-flex printed circuit board 30 comprising rigid multilayer parts or elements 31 and 32 as well as a flexible part 33 and schematically indicating different heights as well as directions of such flexible part or element 33 between rigid parts 31 and 32.

## Claims

1. Method of manufacturing a rigid-flex printed circuit board or a sub-assembly thereof comprising the following steps:
- providing a layer of rigid insulating material (1, 1')
- removing at least one area (2) of the rigid insulating material (1, 1')
- inserting a flexible insulating material (3, 3') into the removed or cut-out area(s) (2) of the rigid insulating material (1, 1')
- covering the rigid and flexible insulating material (1, 1', 3, 3') with a layer of conductive material (4) on at least one surface
- building up at least one further layer (5, 6, 7, 8) of the rigid-flex printed circuit board (10, 20, 30) at least on the rigid part(s) (1, 1') of the insulating material.

2. Method according to claim 1, **characterized in that** the layer of conductive material (4) is structured after having been connected, in particular laminated with the rigid and flexible insulating material (1, 1', 3, 3').

3. Method according to claim 1 or 2, **characterized in that** the rigid and flexible insulating material (1, 1', 3, 3') are covered with a layer of conductive material (4) on both surfaces.

4. Method according to claim 1, 2 or 3, **characterized in that** the layer(s) (4) of conductive material consist(s) of copper.

5. Method according to any of the claims 1 to 4, **characterized in that** the at least one further layer (5, 6, 7, 8) of the rigid-flex printed circuit board (10, 20) is provided on the rigid and the flexible part(s) (1, 1', 3, 3') of the insulating material and is removed at least partially according to the flexible part (3, 3') of the insulating material.

6. Method according to claim 5, **characterized in that** the at least one further layer (5, 6, 7, 8) of the rigid-flex printed circuit board (10, 20) is partly overlapping the flexible area(s) (3, 3') of the insulating material.

7. Method according to any of the claims 1 to 6, **characterized in that** the rigid insulating material (1, 1') and flexible insulating material (3, 3') are connected by gluing or similar connecting techniques.

8. Method according to any of the claims 1 to 7, **characterized in that** after building up further layers (5, 6, 7, 8) of the rigid-flex printed circuit board at least on the rigid part(s) (1) of the insulating material another layer of rigid insulating material (1') is provided comprising at least one flexible part (3') being aligned with the flexible part(s) (3) of the basic rigid and flexible insulating material (1, 3).

9. Method according to any of the claims 1 to 8, **characterized in that** at least the rigid insulating material (1, 1') consists of an insulating prepreg, in particular FR4 or a similar insulating material.

10. Rigid-flex printed circuit board or a sub-assembly thereof comprising the following elements:
- a rigid insulating material (1, 1') comprising at least one area of flexible insulating material (3, 3') having been inserted into a cut-out area (2) of the rigid insulating material (1, 1')
- at least one layer of conductive material (4) on at least one surface of the rigid and flexible insulating material (1, 1', 3, 3')
- at least one further layer (5, 6, 7, 8) of the rigid-flex printed circuit board (10, 20, 30) being provided at least on the rigid part(s) of the insulating material.

11. Rigid-flex printed circuit board or a sub-assembly thereof according to claim 10, **characterized in that** a layer of structured conductive material (4) is provided on at least one surface of the rigid and flexible insulating material (1, 1', 3, 3').

12. Rigid-flex printed circuit board or a sub-assembly thereof according to claim 10 or 11, **characterized in that** the printed circuit board (10, 20) comprises a layer of structured conductive material (4) on both surfaces of the rigid and flexible insulating material (1, 1', 3, 3').

13. Rigid-flex printed circuit board or a sub-assembly thereof according to claim 10, 11 or 12, **characterized in that** the at least one further layer (5, 6, 7, 8) of the rigid-flex printed circuit board is provided on the rigid and the flexible part(s) (1, 1', 3, 3') of the insulating material and is removed at least partially according to the flexible part (3, 3') of the insulating material.

14. Rigid-flex printed circuit board or a sub-assembly thereof according to claim 13, **characterized in that** the at least one further layer (5, 6, 7, 8) of the rigid-flex printed circuit board (10, 20) is partly overlapping the flexible area(s) (3, 3') of the insulating material.

15. Rigid-flex printed circuit board or a sub-assembly thereof according to any of the claims 10 to 14, **characterized in that** the printed circuit board (20) comprises at least two layers of rigid and flexible insulating material (1, 1', 3, 3') being separated by at least one further layer of the rigid-flex printed circuit board, where the areas (3) of flexible insulating material are aligned with each other.

16. Rigid-flex printed circuit board or a sub-assembly thereof according to any of the claims 10 to 15, **characterized in that** the layer(s) (4) of conductive material are made of copper.

17. Rigid-flex printed circuit board or a sub-assembly thereof according to any of the claims 10 to 16, **characterized in that** at least the rigid insulating material (1, 1') consists of an insulating prepreg, in particular FR4 or a similar insulating material.
